# EUROPEAN PATENT APPLICATION

(11) **EP 4 800 409 A1**
(43) Date of publication of application: **02.09.2026**
(21) Application number: 25877807.5
(22) Date of filing: 20.08.2025
(51) Int. Cl.: G01R 31/392, G01R 31/3835, G01R 31/52, G01R 19/12, G01R 19/165, G01R 31/36, G01R 31/367

(54) **BATTERY DIAGNOSIS DEVICE AND METHOD**

(30) Priority: 10.10.2024 KR 20240137245
(71) Applicant: LG Energy Solution, Ltd., Seoul 07335 (KR)
(72) Inventor: LEE, Bokyun, Daejeon 34122 (KR); KIM, Kihoon, Daejeon 34122 (KR); PARK, Hangon, Daejeon 34122 (KR)
(74) Representative: Plasseraud IP
(86) International application number: PCT/KR2025/012608
(87) International publication number: WO 2026/079647

(57) **Abstract**

A battery diagnosis method according to an embodiment of the present invention diagnoses a battery including a plurality of cells, and may comprise the steps of: measuring a cell voltage at regular time intervals; calculating a slope of the cell voltage for each time section determined according to the regular time intervals; and determining whether to initiate one or more cell diagnosis procedures performed in a cell voltage stabilization state, according to the cell voltage slope for each time section and a change tendency of an accumulated cell voltage slope.

## Description

### [Technical Field]

This application claims priority to and the benefit of Korean Patent Application No.10-2024-0137245 filed in the Korean Intellectual Property Office on October 10, 2024 the entire contents of which are incorporated herein by reference.

The present invention relates to an apparatus and method for diagnosing batteries, and more particularly, to an apparatus and method for determining conditions for entering a diagnostic procedure in battery rest state.

### [Background Art]

Secondary batteries, capable of recharging and reuse, are manufactured as battery modules or battery packs by connecting a plurality of battery cells in series based on the required output capacity, serving as power sources for diverse applications. These batteries are used in small, high-tech electronic devices like smart phones, as well as a variety of fields including electric bicycles, electric vehicles, and energy storage systems (ESS).

A battery pack is a structure including a plurality of battery cells. Overvoltage, overcurrent, and overheating in some battery cells may compromise the safety and operational efficiency of the battery pack, making detection of these defects essential. Thus, battery modules or battery packs are usually equipped with a battery management system (BMS) that measures the voltage of each battery cell and monitors and controls the voltage state of the cells based on these measurements. The batteries used in automobiles are also equipped with these BMSs.

Micro-short circuits are one of the faults detected by BMS. Micro-short circuits within a battery can cause leakage current within the battery. In a battery pack containing a plurality of cells, if a micro-short circuit occurs within a single cell, resulting in leakage current, the voltage of the corresponding cell may gradually decrease compared to the voltages of the other cells. The voltage deviation among cells continues to increase may induce surge currents, inrush currents, or over-currents within the battery pack, potentially leading to hard shorts such as sparks, overheating, and circuit damage.

Therefore, a technology to diagnose micro-short circuits within batteries is usually employed to BMSs. BMSs use cell voltages to diagnose micro-short circuits. Prerequisites for this diagnosis include checking whether the contactor is open or closed and the time required for cell voltage stabilization.

However, methods for diagnosing micro-short circuits using cell voltages when these prerequisites are met have limitations in the diagnostic opportunities and insufficient diagnostic accuracy.

Among the prior art documents relevant to the present invention, KR 10-2020-0011014 A is of some relevance.

### [Detailed Description of the Invention]

### [Technical Problem]

To obviate one or more problems of the related art, embodiments of the present disclosure provide a method for determining conditions for entering a diagnostic procedure in battery rest state.

To obviate one or more problems of the related art, embodiments of the present disclosure also provide an apparatus using the battery diagnostic method.

### [Technical Solution]

In order to achieve the objective of the present disclosure, a method for diagnosing a battery including a plurality of cells may include measuring cell voltages at predetermined time intervals; calculating a cell voltage slope for each time section determined based on the predetermined time intervals; and determining whether to initiate one or more cell diagnostic procedures performed in a cell voltage stabilized state, based on the cell voltage slope for each time section and a pattern of change in accumulated cell voltage slopes.

The determining of whether to initiate the cell diagnostic procedure may include determining whether the cell voltage slope decreases in a predetermined number or more of consecutive time sections; and determining whether the cell voltage slope in the last time section is below a threshold.

The the determining of whether to initiate the cell diagnostic procedure may further include determining to initiate the cell diagnostic procedure if the cell voltage slope decreases during the predetermined number or more of consecutive time sections and the cell voltage slope of the last time section is below the threshold.

The one or more cell diagnostic procedures diagnosed in the cell voltage stabilized state may include a diagnosis for detecting an occurrence of a micro-short circuit within the cell.

The the measuring of the cell voltages at predetermined time intervals may include initiating a cell voltage measurement upon receiving a signal indicating termination of operation of a load connected to the battery.

The diagnosis for detecting the occurrence of a micro-short circuit within the cell may include a relaxation delta voltage diagnosis.

In order to achieve another objective of the present disclosure, a battery having a plurality of cells may include at least one processor; and a memory configured to store at least one instruction executed by the at least one processor, and the at least one instruction may include an instruction to measuring cell voltages at predetermined time intervals; an instruction to calculate a cell voltage slope for each time section determined based on the predetermined time intervals; and an instruction to determine whether to initiate one or more cell diagnostic procedures performed in a cell voltage stabilized state, based on the cell voltage slope for each time section and a pattern of change in accumulated cell voltage slopes.

The instruction to determine whether to initiate the one or more cell diagnostic procedures may include an instruction to determine whether the cell voltage slope decreases in a predetermined number or more of consecutive time sections; and an instruction to determine whether the cell voltage slope in the last time section is below a threshold.

The instruction to determine whether to initiate the one or more cell diagnostic procedures may further include an instruction to determine to initiate the cell diagnostic procedure if the cell voltage slope decreases during the predetermined number or more of consecutive time sections and the cell voltage slope of the last time section is below the threshold.

The one or more cell diagnostic procedures diagnosed in the cell voltage stabilized state may include a diagnosis for detecting an occurrence of a micro-short circuit within the cell.

The instruction to measure the cell voltages at predetermined time intervals may include an instruction to initiate a cell voltage measurement upon receiving a signal indicating termination of operation of a load connected to the battery.

The diagnosis for detecting the occurrence of a micro-short circuit within the cell may include a relaxation delta voltage diagnosis.

### [Advantageous Effects]

According to embodiments of the present disclosure, by actively and efficiently determining whether the cell voltage is stabilized, it is possible to more reliably secure an opportunity to perform battery diagnosis that can be performed when the battery state is in an idle period and improve accuracy of the diagnosis performance.

### [Brief Description of the Drawings]

FIG. 1 illustrates an example of a battery pack structure to which embodiments of the present invention can be applied.
FIG. 2 is a conceptual diagram illustrating an example of a battery pack mounted on a vehicle, one application to which the present invention can be applied.
FIG. 3 is a flowchart illustrating a general method of determining whether to initiate a battery diagnostic procedure.
FIG. 4 is a schematic flowchart illustrating a battery diagnostic method according to embodiments of the present invention.
FIG. 5 is a detailed flowchart of a method for determining whether to initiate battery diagnosis according to an embodiment of the present invention.
FIG. 6 is a graph illustrating a concept for determining whether to proceed with diagnosis based on cell voltage slope and slope change patterns according to embodiments of the present invention.
FIG. 7 is a block diagram of a battery diagnostic apparatus according to embodiments of the present invention.
   - 100:: Battery
   - 121, 122:: Contactor
   - 200:: Battery Management System (BMS)
   - 201:: MCU
   - 202:: Memory
   - 300:: Inverter
   - 700:: Battery diagnostic apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

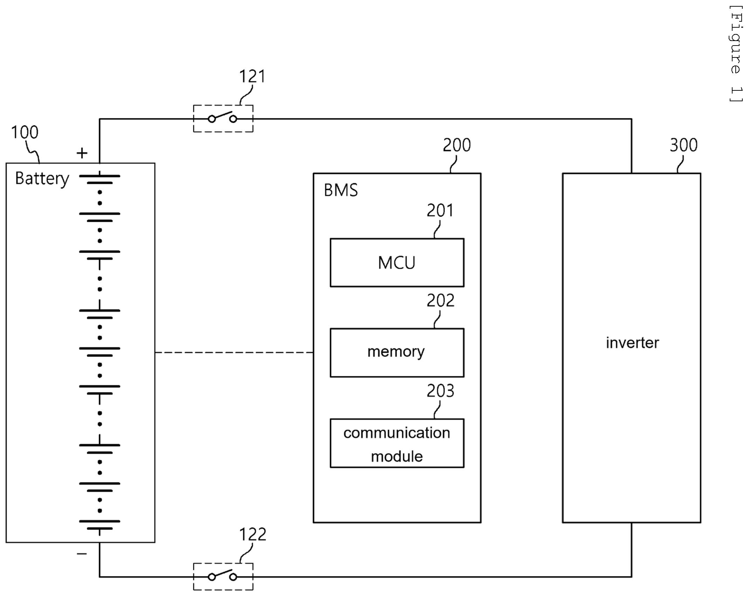

FIG. 1 illustrates an example of a battery pack structure to which embodiments of the present invention can be applied.

In FIG. 1, a battery module 100 may include a plurality of battery cells connected in series and parallel. A battery cell is the basic unit that stores power, and a battery module may refer to an assembly of a plurality of battery cells electrically connected. The most commonly used battery cell is a lithium-ion (Li-Ion) battery cell.

A battery pack may include one or more battery modules, as well as circuits and control devices necessary to manage the battery cells and modules. The battery pack may be connected to a load through positive and negative terminals and perform charging and discharging operations. A battery management system (BMS) may be installed in each battery pack. The BMS 200 installed in each pack, such as those used in automobiles, may monitor the current, voltage, and temperature of each battery pack under its control, calculate the state of charge (SOC) based on the monitoring results, and control charging and discharging. Here, SOC represents the current state of charge of the battery expressed as a percentage [%].

To perform these operations, the BMS 200 may include various components, such as a fuse, a current sensing element, a thermistor, a switch, and a balancer. The BMS 200 typically includes a micro controller unit (MCU) 201 or a Battery Monitoring Integrated Chip (BMIC) for interfacing with and controlling these components. Here, the BMIC may be an IC-type component located within the BMS and capable of measuring information such as voltage, temperature, and current of battery cells/modules.

The BMS 200 may also include a memory 202 configured to store at least one command performed by the MCU 201 and various data generated during the BMS operation. In addition, the BMS may monitor battery cells, read cell voltages, and transmit them to other systems connected to the battery. For this, the BMS may include a communication module 203 for communicating with other systems within a device including the battery system. The BMS communication module may communicate with other systems within the device using a Controller Area Network (CAN). Here, components, modules, or systems within the BMS may be interconnected via the CAN bus.

The processor of the battery diagnostic apparatus according to embodiments of the present invention described below may be implemented as part of a pack BMS, incorporated into the pack BMS.

Meanwhile, the battery pack may drive a load by supplying power to a motor via an inverter 300. The battery module 100 may be connected to or disconnected from the load via contactors 121, 122. The contactors serve as switches that connect the battery pack and the load and control the supply of power, and may include a positive contactor 121 and a negative contactor 122. The positive contactor 121 may be located on a charge/discharge path connected to the positive terminal (+) of the battery pack, and the negative contactor 122 may be located on a charge/discharge path connected to the negative terminal (-) of the battery pack.

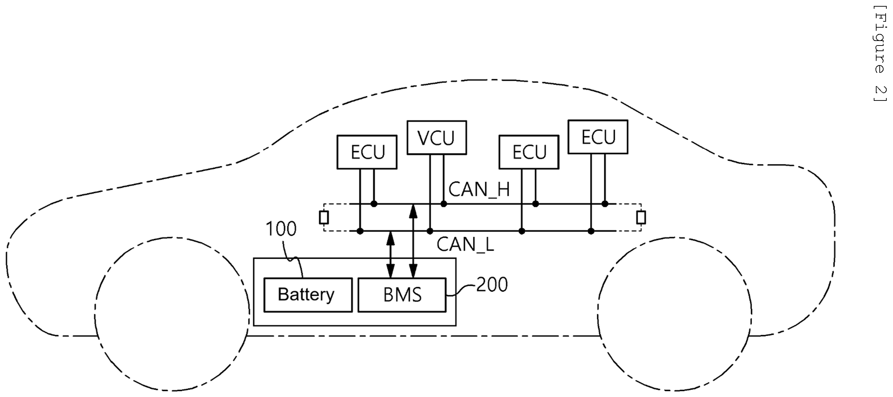

FIG. 2 is a conceptual diagram illustrating an example of a battery pack mounted on a vehicle, one application to which the present invention can be applied.

A battery pack according to embodiments of the present invention can be applied to a vehicle. A vehicle according to embodiments of the present invention may be, for example, an electric vehicle, a hybrid vehicle, or a plug-in hybrid vehicle. Here, the vehicle may include a four-wheeled vehicle or a two-wheeled vehicle. The battery pack supplies power to a motor via an inverter installed in the vehicle, thereby driving the vehicle.

To operate such a vehicle, control operations such as motor drive control, regenerative braking control, air conditioning load control, and electrical load power (12V) supply control may be required. Referring to FIG. 2, a vehicle may include a plurality of electronic control units (ECUs) for these control operations. Among a plurality of ECUs, the top-level controller that comprehensively oversees vehicle operation and control may be referred to as a vehicle control unit (VCU).

The ECU may include internal storage devices such as Random Access Memory (RAM) and Read Only Memory (ROM). The RAM within the ECU temporarily stores various signals generated during vehicle operation. This stored data gradually decays over time and disappears completely if power is cut off. Conversely, the ROM within the ECU records the control data required to operate the vehicle, and this data cannot be arbitrarily erased or altered. When applied to electric vehicles (including hybrid vehicles), the ECU is sometimes called an Electric Power Control Unit (EPCU), controlling the motor and overall vehicle movement.

Meanwhile, a plurality of ECUs within a vehicle can communicate with each other via the CAN bus. The Controller Area Network (CAN) protocol is a standard communication protocol designed for microcontrollers and other devices to communicate with each other without a host computer. The CAN protocol is a message-based network protocol of non-host, bus type, primarily used for communication between controllers, and is primarily used in vehicles.

The CAN protocol uses a multi-master communication method, of which all CAN controllers (ECU, VCU, and BMS in FIG. 2) sharing the communication bus act as masters, allowing each controller to use the CAN bus whenever it wishes. The CAN protocol also uses a message-oriented transmission protocol and two twist pair wires for electrical differentiation, which is highly resistant to electrical noise.

Meanwhile, a battery pack including a battery 100 and a BMS 200 may be mounted on a vehicle. The BMS 200 may communicate with the ECU and VCU within the vehicle using a communication method such as the CAN protocol. The BMS 200 may report battery state information to the vehicle and control the connection between the vehicle and the battery based on vehicle operation information. When the vehicle operation is terminated, the BMS 200 may receives a vehicle shutdown signal from the vehicle's ECU or VCU and stop supplying power from the battery module to the vehicle.

Here, the contactor 121, 122 connecting the battery module and the load is controlled to an open state, and the battery pack may perform various diagnostics to check the state of the battery during a rest or idle period of the battery.

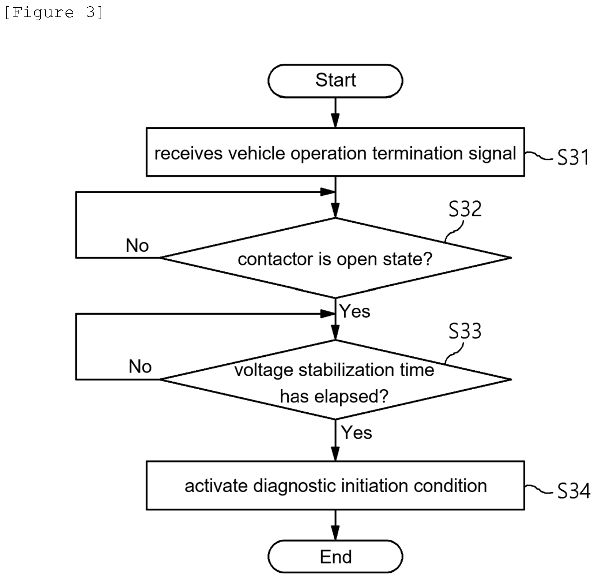

FIG. 3 is a flowchart illustrating a general method of determining whether to initiate a battery diagnostic procedure.

For a battery pack mounted on a vehicle, various diagnostics can be performed on the battery when the battery pack is not in use by the vehicle. Referring to FIG. 3, when the battery pack receives a vehicle operation termination signal (S31), it is determined whether the contactor connecting the battery to the vehicle body is open or closed (S32). Here, the vehicle operation termination signal may include a shutdwn command or ignition-off signal of a vehicle.

If the contactor is open, it is determined whether the voltage stabilization time has elapsed (S33). Here, the voltage stabilization time is estimated to be the time required for the battery's voltage to stabilize after the battery operation is terminated, which is a fixed value that can be preset by a user or administrator.

If it is determined that the voltage has been in a stable state for a predetermined period of time, the diagnostic initiation condition is activated (S34). In other words, since the prerequisites for battery diagnosis have been met, a battery diagnosis procedure can be initiated. Here, battery diagnosis may include one or more cell diagnostic procedures performed while the cell voltage is stable. A representative cell diagnosis is a relaxation delta voltage diagnosis, which detects micro-shorts within the cell.

As such, prerequisites for initiating battery diagnosis generally include determining whether the contactor is closed or open and whether the voltage stabilization time has elapsed. However, there are cases where the contactor remains closed even after operation of the vehicle is terminated (e.g., when charging a 12V battery). In this case, although the cell voltage is relatively stable, the prerequisites for performing battery diagnosis are not met, so the battery diagnosis is not performed.

Furthermore, the method is disadvantageous in terms of accuracy, as it requires waiting for a fixed period of time before performing the diagnosis, even though the cell voltage stabilization tendency may vary depending on the battery's environment.

To address these issues, the present invention proposes a more proactive and efficient method for determining stabilization of cell voltage.

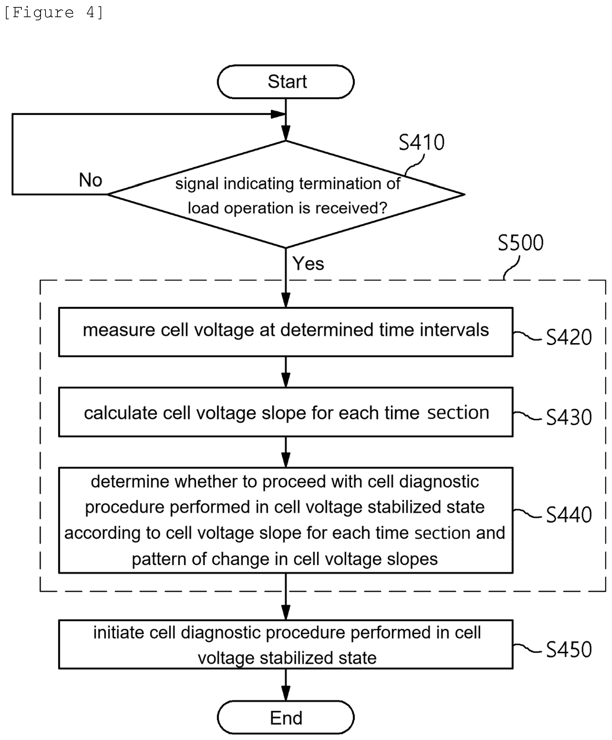

FIG. 4 is a schematic flowchart illustrating a battery diagnostic method according to embodiments of the present invention.

The battery diagnostic method according to embodiments of the present invention may be performed by a battery diagnostic apparatus. The battery diagnostic apparatus according to embodiments of the present invention may include a battery management system (BMS) managing a battery pack or include a part of the BMS.

Referring to FIG. 4, when the battery pack receives a signal indicating the termination of operation of a load connected to the battery (S410), the cell voltage may be measured at determined time intervals (S420). Here, the signal indicating the termination of operation of the load connected to the battery may include an operation termination signal of a vehicle with the battery equipped. Furthermore, the operation termination signal of the vehicle may include a shutdown command or ignition-off signal of the vehicle.

Upon cell voltage value being measured at determined time intervals, a cell voltage slope may be calculated for each time section determined by the determined time interval (S430). Here, the cell voltage slope calculated for each time section may be defined as the ratio of the cell voltage measured in the current cycle to the cell voltage measured in the previous cycle.

When the cell voltage slope for each time section is calculated and accumulated for a certain number of cycles, it can be determined whether to initiate one or more cell diagnostic procedures performed in a cell voltage stabilized state based on the cell voltage slope for each time section and the pattern of change in the accumulated cell voltage slopes (S440). If the initiation of the cell diagnostic procedure is determined, a cell diagnostic procedure that can be performed in a cell voltage stabilized state is initiated (S450). Here, the one or more cell diagnostic procedures diagnosed in the cell voltage stabilized state are diagnostic procedures that can be performed while the battery is in a resting state and may include a diagnosis for detecting the occurrence of a micro-short circuit within a cell. Furthermore, the diagnosis for detecting the occurrence of a micro-short circuit within a cell may include a relaxation delta voltage diagnosis.

Meanwhile, the relaxation delta voltage diagnosis may be performed, for example, by calculating the voltage deviation among a plurality of battery cells, monitoring the pattern of voltage deviation changes, identifying patterns in the voltage deviation changes for each cell, and detecting defective cells exhibiting abnormal patterns.

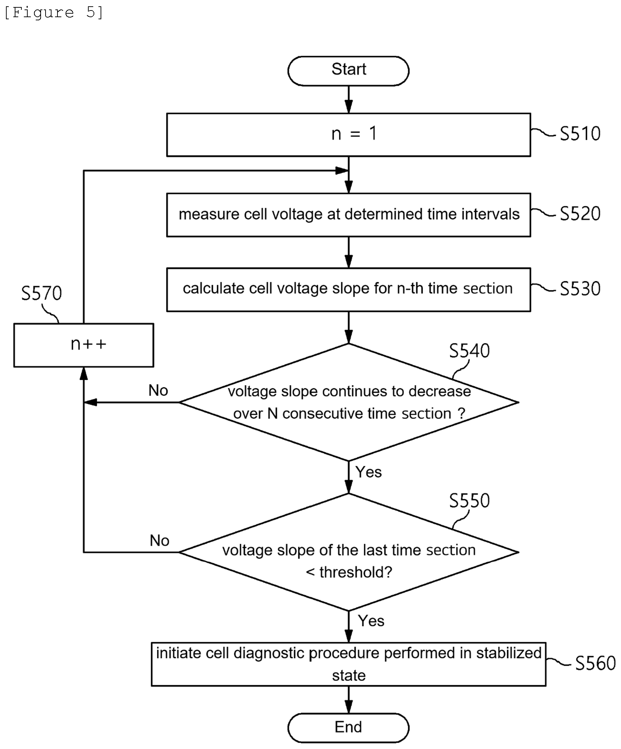

The steps of determining whether to initiate one or more cell diagnostic procedures performed in a cell voltage stabilized state according to the cell voltage slope at each time section and the pattern of accumulated cell voltage slope changes are described in more detail in FIG. 5 below.

FIG. 5 is a detailed flowchart of a method for determining whether to initiate battery diagnosis according to an embodiment of the present invention.

Referring to FIG. 5, a variable n representing time sections divided by a predetermined time interval is initialized (S510), and cell voltages are measured at predetermined time intervals (S520). By measuring cell voltages at predetermined time intervals, the cell voltage slope at the nth time section may be calculated using the cell voltage measured at the (n-1)th time section and the cell voltage measured at the nth time section (S530).

The cell voltage measurement and slope calculation are performed over a plurality of consecutive time sections (S570). Once the cell voltage measurements and slope calculations are completed for a predetermined number of time sections (N), it may be determined whether the measured voltage slope continues to decrease over the N consecutive time sections (S540). In one embodiment, the procedure for determining whether the measured voltage slope continues to decrease over the N consecutive time sections may include determining whether the slope has a negative value over the N consecutive time sections (i.e., whether the voltage value decreases in each section). According to another embodiment, the procedure for determining whether the voltage slope measured in N consecutive time sections continuously decreases may include a process of determining whether the cell voltage slope not only has a negative value (i.e., the voltage value decreases) in N consecutive time sections, but also whether the magnitude of the absolute value of the slope decreases as the cycles repeat, i.e., whether the decrease amount in the decreasing voltage gradually decreases as the cycles repeat. In addition, it is determined whether the voltage slope in the last time section in which cell voltage measurement and slope calculation were performed, i.e., the Nth measurement, is less than a threshold (S550). Here, N is a natural number that can be preset by an administrator or a user.

Although the flowchart of FIG. 5 illustrates that the step of determining whether the voltage slope decreases over a predetermined number of consecutive time sections (S540) is followed by the step of comparing the voltage slope of the last iteration with a threshold (S550), the order of these two steps may be interchanged. In other words, the step of comparing the voltage slope of the last iteration with a threshold (S550) may be performed first, and the step of determining whether the voltage slope decreases over a predetermined number of consecutive time sections (S540) may be performed thereafter.

According to embodiments of the present invention, if the voltage slope decreases over a predetermined number of consecutive time sections and the voltage slope of the last **iteration** is below the threshold, it may be determined to initiate the cell diagnostic procedure (S560).

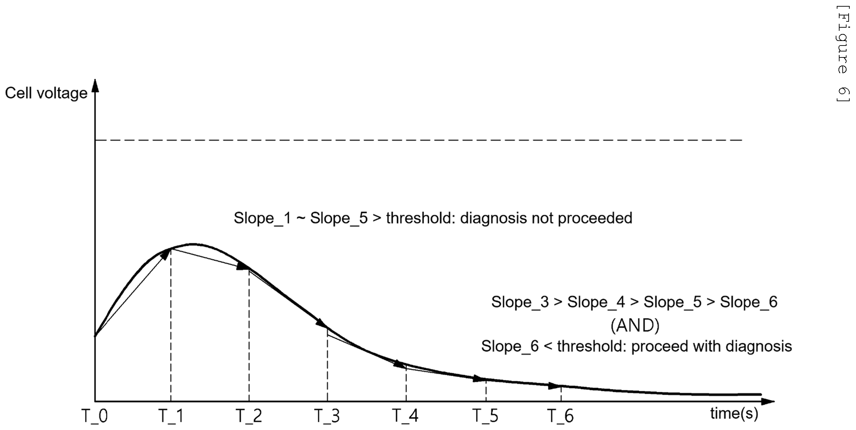

FIG. 6 is a graph illustrating a concept for determining whether to proceed with diagnosis based on cell voltage slope and slope change patterns according to embodiments of the present invention.

In the graph of FIG. 6, the x-axis represents time (s), and the y-axis represents cell voltage (v). Measurement points (T_0, T_1, T_2, T_3, T_4, T_5, T_6) for periodically measuring cell voltage are indicated on the x-axis. Using the first and second cell voltages measured at two measurement points, the slope for the corresponding time section may be calculated. Since the present invention determines the decreasing trend based on the assumption that the voltage decreases, the cell voltage slope herein may be defined as the cell voltage change amount over the T_(n-1) to T_(n) section divided by the time from T_(n-1) to T_(n).

If the cell voltage slope in the first time section (the section between T_0 and T_1) is Slope_1 and the cell voltage slope in the second time section (the section between T_1 and T_2) is Slope_2, Slope_1 is a positive value, and Slope_2 is a negative value. In other words, the cell voltage increased in the first time section and decreased in the second time section. Thereafter, the cell voltage continues to decrease in the third, fourth, fifth, and sixth time sections.

According to one embodiment of the present invention, it is assumed that the number of time sections set to determine a continuous voltage slope decrease in consecutive time sections is four. Here, if, for example, the decision on whether to proceed with battery diagnosis is made in the fourth time section, as shown in the graph of FIG. 6, the cell voltage slope values calculated in the first, second, third, and fourth time sections are all determined to be above the threshold value for initiating battery cell diagnosis, preventing the diagnosis process from proceeding.

As another example, let's consider a case where a decision is made on whether to proceed with a battery diagnosis in the sixth time section. Here, the cell voltage slope is negative from the third to sixth time sections, which means that the cell voltage is decreasing from the third to sixth time sections. Furthermore, the absolute value of the slope is continuously decreasing throughout these time sections. In other words, not only does the voltage slope have a negative value (i.e., the voltage value is decreasing) for four consecutive time sections, but the magnitude of the absolute value of the slope decreases with each iteration, which means that the magnitude of the voltage decrease is gradually decreasing with each iteration.

In addition, the slope in the sixth time section is confirmed to be below the threshold, which is the condition for initiating a battery cell diagnosis. Thus, since both the voltage decreases and the voltage slope decrease for a certain number of consecutive time sections and the voltage slope in the last time section is below the threshold, battery diagnosis can be initiated.

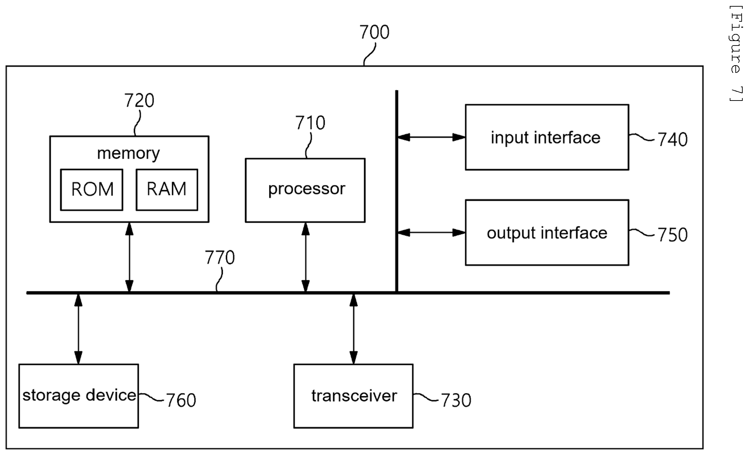

FIG. 7 is a block diagram of a battery diagnostic apparatus according to embodiments of the present invention.

Referring to FIG. 7, the battery diagnostic apparatus 700 according to embodiments of the present invention may include a processor 710; and a memory 720 that stores at least one instruction executed by the processor. Here, the processor may be, for example, an Micro Controller Unit (MCU) or another type of controller. The battery diagnostic apparatus 700 may also be connected to one or more devices that measure cell voltage and may receive cell voltage measurements from the devices.

Here, the at least one instruction executed by the processor may include an instruction to measuring cell voltages at predetermined time intervals; an instruction to calculate a cell voltage slope for each time section determined based on the predetermined time intervals; and an instruction to determine whether to initiate one or more cell diagnostic procedures performed in a cell voltage stabilized state, based on the cell voltage slope for each time section and a pattern of change in accumulated cell voltage slopes.

The instruction to determine whether to initiate one or more cell diagnostic procedures may include an instruction to determine whether the cell voltage slope decreases in a predetermined number or more of consecutive time sections; and an instruction to determine whether the cell voltage slope in the last time section is below a threshold.

The instruction to determine whether to initiate one or more cell diagnostic procedures may further include an instruction to determine to initiate the cell diagnostic procedure if the cell voltage slope decreases during the predetermined number or more of consecutive time sections and the cell voltage slope of the last time section is below a threshold.

The one or more cell diagnostic procedures diagnosed in the cell voltage stabilized state may include a diagnosis for detecting an occurrence of a micro-short circuit within the cell.

The instruction to measure the cell voltages at predetermined time intervals may include an instruction to initiate the cell voltage measurement upon receiving a signal indicating termination of operation of a load connected to the battery.

The diagnosis for detecting the occurrence of a micro-short circuit within the cell may include a relaxation delta voltage diagnosis.

The controller of the battery diagnostic apparatus according to embodiments of the present invention, for example, the processor 710, may be included and configured in a BMS. In other words, the controller of the battery diagnostic apparatus according to embodiments of the present invention may be an MCU within the BMS or another type of controller.

Meanwhile, the battery diagnostic apparatus 700 according to embodiments of the present invention may further include an input interface device 740, an output interface device 750, a storage device 760, etc. Respective components included in the battery diagnostic apparatus 700 may be connected by a bus 770 and can communicate with each other.

Furthermore, the memory 720 may include at least one of a volatile storage medium and a non-volatile storage medium. For example, the memory may include at least one of read only memory (ROM) and random access memory (RAM), and may include an Electrically Erasable Programmable Read-only Memory (EEPROM).

According to the embodiments of the present invention as described above, by actively and efficiently determining whether cell voltage is stabilized, an opportunity to perform battery diagnosis, which may be performed when the battery is in idle state, can be more reliably secured and the accuracy of the diagnosis can be improved.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A method for diagnosing a battery including a plurality of cells, comprising:
measuring cell voltages at predetermined time intervals;
calculating a cell voltage slope for each time section determined based on the predetermined time intervals; and
determining whether to initiate one or more cell diagnostic procedures performed in a cell voltage stabilized state, based on the cell voltage slope for each time section and a pattern of change in accumulated cell voltage slopes.

2. The method for diagnosing the battery of claim 1, wherein the determining of whether to initiate the cell diagnostic procedure includes:
determining whether the cell voltage slope decreases in a predetermined number or more of consecutive time sections; and
determining whether the cell voltage slope in the last time section is below a threshold.

3. The method for diagnosing the battery of claim 2, wherein the determining of whether to initiate the cell diagnostic procedure further includes:
determining to initiate the cell diagnostic procedure if the cell voltage slope decreases during the predetermined number or more of consecutive time sections and the cell voltage slope of the last time section is below the threshold.

4. The method for diagnosing the battery of claim 1, wherein the one or more cell diagnostic procedures diagnosed in the cell voltage stabilized state include a diagnosis for detecting an occurrence of a micro-short circuit within the cell.

5. The method for diagnosing the battery of claim 1, wherein the measuring of the cell voltages at predetermined time intervals includes:
initiating a cell voltage measurement upon receiving a signal indicating termination of operation of a load connected to the battery.

6. The method for diagnosing the battery of claim 5, wherein the signal indicating the termination of operation of the load connected to the battery includes a signal indicating an operation termination of a vehicle equipped with the battery.

7. The method for diagnosing the battery of claim 4, wherein the diagnosis for detecting the occurrence of a micro-short circuit within the cell includes a relaxation delta voltage diagnosis.

8. An apparatus for diagnosing a battery including a plurality of cells, the apparatus comprising:
at least one processor; and
a memory configured to store at least one instruction executed by the at least one processor,
wherein the at least one instruction includes:
an instruction to measuring cell voltages at predetermined time intervals;
an instruction to calculate a cell voltage slope for each time section determined based on the predetermined time intervals; and
an instruction to determine whether to initiate one or more cell diagnostic procedures performed in a cell voltage stabilized state, based on the cell voltage slope for each time section and a pattern of change in accumulated cell voltage slopes.

9. The apparatus for diagnosing the battery of claim 8, wherein the instruction to determine whether to initiate the one or more cell diagnostic procedures includes:
an instruction to determine whether the cell voltage slope decreases in a predetermined number or more of consecutive time sections; and
an instruction to determine whether the cell voltage slope in the last time section is below a threshold.

10. The apparatus for diagnosing the battery of claim 9, wherein the instruction to determine whether to initiate the one or more cell diagnostic procedures further includes:
an instruction to determine to initiate the cell diagnostic procedure if the cell voltage slope decreases during the predetermined number or more of consecutive time sections and the cell voltage slope of the last time section is below the threshold.

11. The apparatus for diagnosing the battery of claim 8, wherein the one or more cell diagnostic procedures diagnosed in the cell voltage stabilized state include a diagnosis for detecting an occurrence of a micro-short circuit within the cell.

12. The apparatus for diagnosing the battery of claim 8, wherein the instruction to measure the cell voltages at predetermined time intervals includes:
an instruction to initiate a cell voltage measurement upon receiving a signal indicating termination of operation of a load connected to the battery.

13. The apparatus for diagnosing the battery of claim 12, wherein the signal indicating the termination of operation of the load connected to the battery includes a signal indicating an operation termination of a vehicle equipped with the battery.

14. The apparatus for diagnosing the battery of claim 11, wherein the diagnosis for detecting the occurrence of a micro-short circuit within the cell includes a relaxation delta voltage diagnosis.

15. A computer-readable medium having recorded thereon a program for executing the method for diagnosing the battery according to any one of claims 1 to 7 on a computer.
